# EUROPÄISCHE PATENTSCHRIFT

(11) **EP 0 953 206 B1**
(45) Veröffentlichungstag und Bekanntmachung des Hinweises auf die Patenterteilung: **26.04.2006**
(21) Anmeldenummer: 97923787.2
(22) Anmeldetag: 07.05.1997
(51) Int. Cl.: H01L 21/60, B23K 26/02, B23K 1/005

(54) **VORRICHTUNG ZUR ORTSGENAUEN FIXIERUNG EINES MIKROCHIPS**
DEVICE FOR PRECISE LOCATION OF A MICROCHIP
DISPOSITIF POUR L'IMPLANTATION PRECISE D'UNE MICROPUCE

(30) Priorität: 08.05.1996 DE 19618533
(43) Veröffentlichungstag der Anmeldung: 03.11.1999
(73) Patentinhaber: Infineon Technologies AG, 81669 München (DE)
(72) Erfinder: BOGNER, Georg, D-93138 Hainsacker (DE); ALTHAUS, Hans-Ludwig, D-93138 Lappersdorf (DE)
(74) Vertreter: Gross, Felix
(86) Internationale Anmeldenummer: PCT/DE1997/000926
(87) Internationale Veröffentlichungsnummer: WO 1997/042653

(56) Entgegenhaltungen:
- EP-A- 0 209 650
- EP-A- 0 326 020
- EP-A- 0 491 192
- DESIGN ENGINEERING, Juni 1987, Seite 25, 28 XP002028832 "SENSOR-BASED LASER SCANNER LINKS SOLDER JOINT INTEGRITY TO PRODUCTION LINE PERFORMANCE"
- INSTRUMENTS AND EXPERIMENTAL TECHNIQUES, Bd. 30, Nr. 6, PART 2, November 1987, Seite 1494/1495 XP000045151 RYABUKHO V P ET AL: "SOK-1 LASER OPTICAL SYSTEM WITH TELEVISION ATTACHMENT"

## Beschreibung

Die Erfindung betrifft eine Vorrichtung zur ortsgenauen Fixierung eines Mikröchips auf einem Träger mit einer als Strahlungsheizung ausgebildeten Heizeinrichtung zur Zuführung von Heizstrahlung zum Befestigen des Mikrochips auf dem Träger durch Erhitzung und Lötung, wobei die Heizstrahlung durch eine Abbildungsoptik auf den Mikrochip geführt ist, und mit einer optischen Überwachungseinrichtung, die derselben Abbildungsoptik zugeordnet ist.

Der Begriff Mikrochip ist weit auszulegen. Dies können beispielsweise Halbleiterdioden oder Mikrolinsen sein, die hochgenau auf einem Träger, der auch Submount genannt wird, montiert werden sollen.

Bekannte Verfahren der eingangs genannten Art zeichnen sich dadurch aus, daß der Mikrochip mit einer Saugdüse oder einer Zange aufgenommen und mit Hilfe von Mikromanipulatoren in die gewünschte Position gebracht wird. Die exakte Einstellung der Position erfolgt mit Hilfe eines Bilderkennungssystems, welches üblicherweise eine Kamera mit einem Tubus und einer Abbildungsoptik aufweist und sich axial über der Montageposition befindet. Der Mikrochip wird dann auf den jeweiligen Träger abgesenkt. Durch Erhitzung werden Mikrochip und Träger miteinander verlötet bzw. verklebt. Als Heizung kommen dabei eine Widerstandsheizung, eine Gasheizung oder auch eine Strahlungsheizung in Betracht. Dabei entsteht das Problem, daß auf relativ engem Raum eine Vielzahl von Subkomponenten für die Heizquelle und die axiale Positionsüberwachung räumlich nebeneinander in einer Anlage montiert werden müssen. Zudem gelingt es nicht immer optimal, die Heizenergie an die richtige Position zu bringen.

Aus "Design Engineering", Juni 1987, London, Seite 25 "Sensor Based Laser Scanner Links ..." ist bekannt, einen Laser als Strahlungsheizung zur Fixierung eines Mikrochips auf einen Träger zu verwenden und die Heizstrahlung durch die Abbildungsoptik einer optischen Positions-Überwachung zu führen.

Sowohl die Kamera als auch die Austrittsoptik des Laserstrahls aus einem Faserkabel sind seitlich neben dem Lichtweg der Abbildungsoptik angeordnet, so daß sowohl die optische Strahlung der Positionsüberwachung als auch die Heizstrahlung des Lasers über geneigte halbdurchlässige Spiegel in den Strahlengang der Abbildungsoptik eingespiegelt werden müssen. Unmittelbar im Strahlengang der Abbildungsoptik ist ein Detektor für infrarotes Licht angeordnet, mit welchem die Qualität der Lötverbindungen anhand von charakteristischen Strahlungsverläufen der IR-Strahlung überwacht wird. Die IR-Strahlung gelangt von der Abbildungsoptik durch die beiden halbdurchlässigen Spiegel hindurch in den IR-Detektor. Die Heizstrahlung wird also vom Laser kommend zunächst über einen Strahlteiler auf das Bauteil gerichtet und von dort reflektiert. Nur die reflektierte Heizstrahlung gelangt systembedingt durch den Strahlteiler des Lasers und den Strahlteiler der Überwachungskamera hindurch zum IR-Detektor.

Diese Anordnung hat den Nachteil, daß eine Nachregelung der Heizstrahlung erst erfolgen kann, wenn tatsächlich Lötverbindungen hergestellt und analysiert wurden. Es ist daher unausweichlich, daß im Falle einer falsch eingestellten Heizstrahlung zunächst einige Fehl-Lötungen durchgeführt werden, bevor das System reagieren kann. In einem solchen Fall fällt daher zwangsläufig immer Ausschuß an.

Aus "Instruments and experimental techniques", vol. 30, no. 6, Teil 2, November 1987, Seiten 1494/1495 ist bei einer gattungsgemäßen Anordnung bekannt, anstelle eines IR-Detektors eine Beobachtungsoptik anzubringen, über welche ein Bediener die Lötstelle betrachten kann. Dazu wird Licht über einen Drehspiegel von der Abbildungsoptik eingeleitet. Vor der Beobachtungsoptik und dem Eingang einer Überwachungskamera liegt ein Lichtfilter im Wege der reflektierten Heizstrahlung.
Ahnliche Vorrichtungen der vorstehend beschriebenen Art sind ferner aus EP 0 326 020 A und EP 0 491 192 A bekannt.

Der Erfindung liegt die **Aufgabe** zugrunde, eine Vorrichtung der eingangs genannten Art zu schaffen, die besonders kompakt ausgebildet ist und mit der eine besonders genaue Positionierung und Fixierung des Mikrochips auf dem Träger möglich ist.

Die Aufgabe wird erfindungsgemäß dadurch gelöste siehe Anspruch 1, daß die optische Überwachungseinrichtung als optische Positionsüberwachung zur ortsgenauen Justierung des Mikrochips auf dem Träger ausgebildet ist.

Der wesentliche Vorteil der Erfindung besteht darin, daß die Heizenergie zum Löten bzw. Kleben des Mikrochips direkt in den Mikrochip selbst eingebracht werden kann. Hierzu wird die gleiche Abbildungsoptik verwendet, die zur Beobachtung des Mikrochips und zur Kontrolle der Justageposition mittels der optischen Überwachungseinrichtung verwendet wird. Auf diese Weise wird eine koaxiale optische Leistungskopplung zur simultanen Justierung und Fixierung geschaffen.

In einer bevorzugten Ausführungsform der Erfindung ist die optische Postionsüberwachung in einer optischen Achse der Abbildungsoptik angeordnet. Die Heizstrahlung und für die optische Positionsüberwachung erkennbare Strahlung werden seitlich zugeführt und mit Hilfe optischer Elemente in die optische Achse der Abbildungsoptik eingespiegelt. Dazu werden Spiegel oder bevorzugt Strahlteiler verwendet. Hinter den Strahlteilern können in einer bevorzugten Weiterbildung der Erfindung Überwachungssysteme zur Kontrolle und Regelung der Strahlungsleistung angeordnet sein. Dazu können beispielsweise Fotodioden verwendet werden. Die Strahlteiler sind dabei so gestaltet, daß mehr als 90 % der Strahlungsleistung in Richtung Abbildungsoptik gelenkt wird und nur ein kleiner Rest auf die Fotodiode trifft.

Die optische Postionsüberwachung weist eine Kamera, einen tubusförmigen Körper und eine Abbildungsoptik auf, wobei die Kamera bevorzugt in der optischen Achse der Abbildungsoptik angeordnet ist. Vor der Kamera ist vorteilhafterweise ein Filter, insbesondere ein Kantenfilter, angeordnet, der nur für das Licht der optischen Positionsüberwachung, also für sichtbares Licht oder Infrarotlicht, durchlässig und für die Wellenlänge der Heizstrahlung undurchlässig ist. Durch diese Maßnahme wird die Kamera wirksam vor der Heizstrahlung der Heizeinrichtung geschützt.

Zur Erzeugung der Heizstrahlung ist bevorzugt ein Laser vorgesehen, da mit diesem eine sehr hohe Energiedichte erreichbar ist. Besonders eignen sich hier NdYag-Laser oder ein fasergebündeltes Hochleistungs-Halbleiterlasersystem. Auch eine Xenon-Dampflampe oder ähnliches kann unter Umständen eingesetzt werden.

Von Vorteil ist es, wenn zur Zuführung der Heizstrahlung zur Vorrichtung ein Lichtleiter vorgesehen ist. Wenn das Licht mittels einer Faser oder eines Faserbündels in den Tubus eingestrahlt wird, kann der Tubusaufbau sehr klein gestaltet werden.

In einer anderen Weiterbildung der Erfindung ist eine Optik zur Parallelisierung und Fokusregelung der Heizstrahlung vorgesehen, damit die Fokuslagen für die Heizstrahlung und die Überwachungsstrahlung in Übereinstimmung gebracht werden können. Diese Optik dient außerdem dazu die Heizstrahlung zunächst zu parallelisieren.

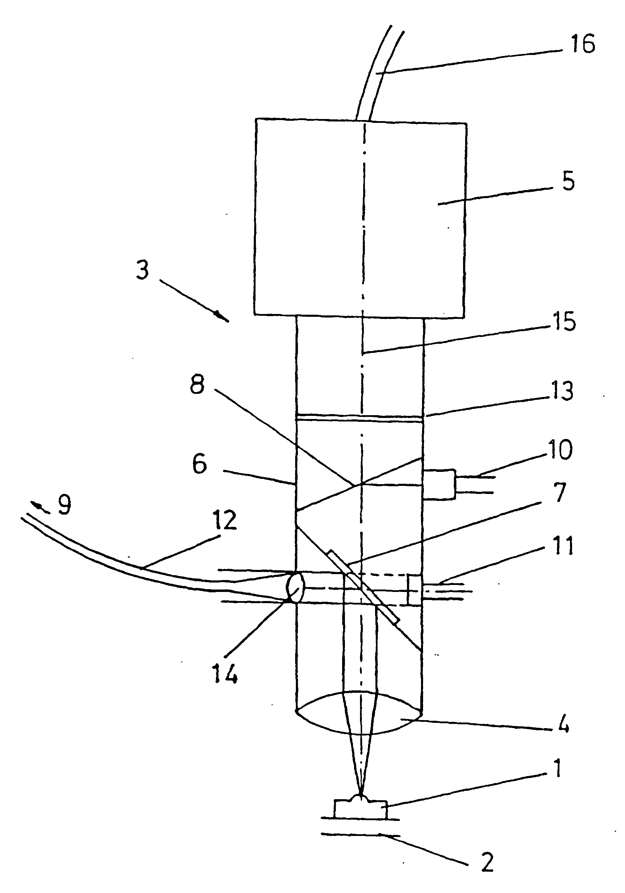

Die Erfindung wird anhand der einzigen Figur der Zeichnung weiter erläutert. In dieser Figur ist der Aufbau einer erfindungsgemäßen Vorrichtung schematisch dargestellt.

Im unteren Bereich der Figur ist ein Mikrochip 1 dargestellt, der auf einem Träger 2 ruht. Die optische Positionsüberwachung 3 besteht im wesentlichen aus einer Kamera 5, einem Tubus 6 und einer Abbildungsoptik 4. Die Abbildungsoptik 4 weist eine optische Achse 15 auf, in welcher die Kamera 5 zentriert angeordnet ist. Eine Beleuchtungseinrichtung 10 zur Bilderkennung erzeugt sichtbares oder Infrarotlicht, welches seitlich in den Tubus 6 eingespeist wird. Über einen Strahlteiler 8 wird dieses Licht auf der optischen Achse 15 in Richtung Mikrochip 1 abgelenkt. Die optische Achse 15 verläuft axial im Zentrum des Tubus 6. Eine Heizeinrichtung 9, die im vorliegenden Fall als Laser ausgebildet ist, erzeugt Heizstrahlung, die über eine Faser 12 seitlich an den Tubus 6 herangeführt wird. Am Ende der Faser 12 ist eine Optik 14 zur Parallelisierung der Heizstrahlung vorgesehen, so daß die Heizstrahlung parallel auf einen Strahlteiler 7 fällt, und von diesem zu über 90 % in Richtung Abbildungsoptik 4 und Mikrochip 1 abgelenkt wird. Durch die Parallelisierungsoptik 14 wird erreicht, daß die Heizstrahlung ebenfalls auf der optischen Achse 15 der Abbildungsoptik eingestrahlt wird und die Fokuslage der Heizstrahlung einstellbar wird und z.B. mit der Fokuslage des Lichts zur Bilderkennung übereinstimmen kann. Der Strahlteiler 7 läßt einen kleinen Anteil der Heizstrahlung passieren, so daß dieser Anteil, der unter 10 % der Strahlungsleistung liegt, auf ein Überwachungssystem 11 fällt, welches als wesentlichen Bestandteil eine Fotodiode aufweist. Mit diesem Überwachungssystem 11 kann die Strahlungsenergie gemessen und entsprechend den Anforderungen geregelt werden. Zwischen den seitlichen Anschlüssen für die Beleuchtungseinrichtung und für die Heizeinrichtung und der Kamera ist ein Kantenfilter 13 vorgesehen, der nur für das Licht der Beleuchtungseinrichtung durchlässig und im Wellenlängenbereich der Heizeinrichtung undurchlässig ist. Die Kamera 5 weist außerdem einen Anschluß 16 auf, mit dem die aufgenommenen. Bilder einer Datenverarbeitung zugeführt werden.

Mit dieser Vorrichtung wird ein sehr günstiges Verfahren zur Justierung und Fixierung von Mikrochips möglich. Zunächst wird die Ablageposition für den Mikrochip, insbesondere für eine Linse, mit der Kamera eingestellt. Der Mikrochip wird mit einem Mikromanipulator in diese Position gebracht und dort abgelegt. Mit Hilfe eines Lichtpulses wird der Mikrochip durch die Optik des Bilderkennungssystems fixiert. Dadurch ist gewährleistet, daß der Mikrochip exakt positioniert ist und daß genau die Position, die es aufzuheizen gilt, auch wirklich geheizt wird.

### Bezugszeichenliste

- 1: Mikrochip
- 2: Träger
- 3: optische Positionsüberwachung
- 4: Abbildungsoptik
- 5: Kamera -
- 6: Tubus
- 7: Strahlteiler für Heizstrahlung
- 8: Strahlteiler für Beleuchtung
- 9: Heizstrahlungsquelle
- 10: Beleuchtungseinrichtung
- 11: Überwachungssystem
- 12: Faser
- 13: Kantenfilter
- 14: Optik zur Parallelisierung
- 15: optische Achse
- 16: Anschluß für Datenverarbeitung

## Patentansprüche

1. Vorrichtung zur ortsgenauen Fixierung eines Mikrochips (1) mit einem als Strahlungsheizung dienenden Laser (9) auf einem Träger (2) zur Zuführung von Heizstrahlung über eine Faser (12) und eine Parallelisierungsoptik (14) am Ende der Faser (12), wobei die Heizstrahlung über einen Strahlteiler durch eine Abbildungsoptik (4) einer optischen Positionsüberwachung (3) geführt ist,
**dadurch gekennzeichnet,**
**daß** in Austrittsrichtung der Heizstrahlung aus der Parallelisierungsoptik (14) der Faser (12) hinter dem Strahlteiler ein Überwachungssystem (11) zur Kontrolle und Regelung der Strahlungsleistung vorgesehen ist.

2. Vorrichtung nach Anspruch 1,
**dadurch gekennzeichnet,**
**daß** der Strahlteiler (7) mehr als 90 % der Heizstrahlung in Richtung der Abbildungsoptik (4) ablenkt.

## Revendications

1. Dispositif d'immobilisation précise en emplacement d'une micropuce (1), comprenant un laser (9) servant de chauffage par rayonnement sur un support (2) pour l'apport de rayonnement de chauffage par une fibre (12) et une optique (14) de parallélisation à l'extrémité de la fibre (12), le rayonnement de chauffage étant guidé par l'intermédiaire d'un diviseur de faisceaux dans une optique (4) de reproduction d'un contrôle (3) à optique de position,
**caractérisé**
**en ce qu'**il est prévu, dans le sens de sortie du rayonnement de chauffage de l'optique (14) de parallélisation de la fibre (12), en aval du diviseur de faisceaux, un système (11) de contrôle et de régulation de la puissance du rayonnement.

2. Dispositif suivant la revendication 1, **caractérisé en ce que** le diviseur (7) de faisceaux dévie plus de 90 % du rayonnement de chauffage dans la direction de l'optique (4) de reproduction.

## Claims

1. Device for the positionally accurate fixing of a microchip (1), having a laser (9) which serves as a radiant heater on a carrier (2) and is intended to supply thermal radiation via a fibre (12) and a parallelizing optical system (14) on the end of the fibre (12), the thermal radiation being guided via a beam splitter through an imaging optical system (4) of an optical position monitor (3), **characterized in that** a monitoring system (11) for monitoring and controlling the radiant power is provided downstream of the beam splitter in the exit direction of the thermal radiation from the parallelizing optical system (14) of the fibre (12).

2. Device according to Claim 1, **characterized in that** the beam splitter (7) deflects more than 90% of the thermal radiation in the direction of the imaging optical system (4).
